# EUROPÄISCHE PATENTSCHRIFT

(11) **EP 4 022 396 B1**
(45) Veröffentlichungstag und Bekanntmachung des Hinweises auf die Patenterteilung: **18.03.2026**
(21) Anmeldenummer: 20750638.7
(22) Anmeldetag: 31.07.2020
(51) Int. Cl.: G03F 9/00

(54) **VERFAHREN UND BELICHTUNGSEINRICHTUNG ZUR BELICHTUNG EINES LICHTEMPFINDLICHEN AUFZEICHNUNGSTRÄGERS**
METHOD AND EXPOSURE DEVICE FOR EXPOSING A LIGHT-SENSITIVE RECORDING MEDIUM
PROCÉDÉ ET DISPOSITIF D'EXPOSITION SERVANT À EXPOSER UN SUPPORT D'ENREGISTREMENT SENSIBLE À LA LUMIÈRE

(30) Priorität: 26.08.2019 DE 102019122839
(43) Veröffentlichungstag der Anmeldung: 06.07.2022
(73) Patentinhaber: MIVA Technologies GmbH, 71101 Schönaich (DE)
(72) Erfinder: PAGAN, Robin, 70563 Stuttgart (DE)
(74) Vertreter: Mammel und Maser Patentanwälte PartG mbB
(86) Internationale Anmeldenummer: PCT/EP2020/071624
(87) Internationale Veröffentlichungsnummer: WO 2021/037475

(56) Entgegenhaltungen:
- DE-B3- 102018 106 544
- US-A- 4 635 788
- US-A1- 2012 056 105
- US-A1- 2014 146 299

## Beschreibung

Die Erfindung betrifft ein Verfahren zur Belichtung von zumindest einer gespeicherten Darstellung auf einem lichtempfindlichen Aufzeichnungsträger sowie eine Belichtungseinrichtung zur Durchführung des Verfahrens.

Aus der DE 20 2016 001 967 U1 ist eine Belichtungseinrichtung bekannt, welche mindestens zwei auf einer gemeinsamen Führungsachse verschiebbare Belichtungsköpfe aufweist, welche oberhalb einer Auflage für einen Aufzeichnungsträger verfahrbar sind. Diese Belichtungsköpfe sind entlang einer verfahrbaren Führungsachse in X-Richtung verschiebbar, wobei die verfahrbare Führungsachse in Y-Richtung verfahrbar ist. Dadurch können die Belichtungsköpfe in verschiedenen Positionen zum Aufzeichnungsträger ausgerichtet werden, um gespeicherte Darstellungen auf einem ebenen lichtempfindlichen Aufzeichnungsträger zu belichten.

Aus der DE 10 2017 123 686 A1 sind des Weiteren ein Verfahren sowie eine Belichtungseinrichtung zur Belichtung von zumindest einer gespeicherten Darstellung auf einem lichtempfindlichen Aufzeichnungsträger bekannt. Diese Belichtungseinrichtung umfasst zumindest einen Belichtungskopf, der entlang einer Führungsachse in X-Richtung verfahren wird, wobei die Führungsachse in Y-Richtung verfahren wird. Eine Auflage als verschiebbarer Tisch zur Aufnahme des Aufzeichnungsträgers wird aus einer Prozesskammer der Belichtungseinrichtung herausgefahren, um den Aufzeichnungsträger darauf zu positionieren. Darauffolgend wird die Auflage mit dem Aufzeichnungsträger in die Prozesskammer in Y-Richtung eingeschoben. Während dieser Verfahrbewegung wird die Lage des Aufzeichnungsträgers durch zumindest eine linienförmige Bilderfassungseinrichtung erfasst. Nach dem Belichten des Aufzeichnungsträgers wird die Auflage herausgefahren und der belichtete Aufzeichnungsträger entnommen.

Aus der US 2014/0146299 A1 ist eine Belichtungsvorrichtung sowie ein Verfahren zur Korrektur einer Ausrichtung eines zu belichtenden Aufzeichnungsträgers bekannt. In einer Prozesskammer der Belichtungsvorrichtung ist ein Belichtungskopf zur Belichtung des Aufzeichnungsträgers vorgesehen. Des Weiteren sind eine Scan-Vorrichtung sowie Bilderfassungseinrichtungen in Form von Kameras vorgesehen, die ergänzend zu einem Bildsensor Daten erfassen. Zur Ermittlung der Ausrichtung wird der Aufzeichnungsträger auf eine Bühne innerhalb der Prozesskammer aufgelegt. Diese Bühne kann sowohl in Richtung auf den Belichtungskopf als auch in einer Verfahrrichtung rechtwinklig dazu zur Ermittlung verschiedener Positionen des Aufzeichnungsträgers verfahren werden.

Aus der DE 10 2018 106 544 B3 ist ein Verfahren und eine Vorrichtung zum Transport einer Anordnung flexibler Schaltungssubstrate während der Herstellung eines Verbundes darauf bekannt. Auf einem Transportband werden mehrere Schaltungssubstrate übereinanderliegend positioniert. Diese Schaltungssubstrate werden von einer Folie vollständig überdeckt. Darauffolgend wird ein Unterdruck erzeugt, um über die Folie auf die übereinanderlappend angeordneten Schaltungssubstrate eine Anpresskraft aufzubringen.

Aus der US 4 635 788 A ist ein Kettenförderband bekannt, welches durch Zahnritzel angetrieben ist. Mehrere Auflagen, auf denen jeweils ein Chip vereinzelt aufliegt, werden durch eine Zone transportiert, in der Luftströme auf den Chip gerichtet sind.

Aus der US 2012/0056105 A ist eine Vorrichtung und ein Verfahren zur Herstellung von Flachbildschirmen bekannt.

Aus einem Prospekt der Manz AG, Steigäckerstraße 5, 72768 Reutlingen mit dem Titel "PLI 400 SpeedLight" ist des Weiteren eine Belichtungsmaschine für eine Direktbelichtung bekannt, welche ein doppeltes Auflagesystem umfasst. Vor der Prozesskammer der Belichtungseinrichtung ist eine Beladestation mit einer ersten Auflage als verschiebbare Palette vorgesehen. In der Beladestation ist des Weiteren darunterliegend eine zweite verschiebbare Palette mit einer Auflage angeordnet. Nachdem die erste Auflage in die Prozesskammer eingefahren wird, wird die zweite Auflage angehoben, um mit einem weiteren Aufzeichnungsträger bestückt zu werden. Nach der Belichtung des ersten Aufzeichnungsträgers wird die Auflage mit dem zweiten Aufzeichnungsträger abgesenkt, die Auflage mit dem ersten Aufzeichnungsträger aus der Bearbeitungsmaschine herausgeführt und die zweite Auflage in die Prozesskammer eingeführt und in eine Bearbeitungsposition angehoben. Zwar kann bei dieser Belichtungseinrichtung parallel zum Belichten eines Aufzeichnungsträgers in der Prozesskammer ein Be- und Entladen eines weiteren Aufzeichnungsträgers in der Be- und Entladestation erfolgen, jedoch ist die Prozessdauer durch das Be- und Entladen und die Verfahrbewegungen der Auflagen beziehungsweise Paletten in der Belichtungseinrichtung begrenzt.

Der Erfindung liegt die Aufgabe zugrunde, ein Verfahren und eine Belichtungseinrichtung zur Belichtung eines lichtempfindlichen Aufzeichnungsträgers vorzuschlagen, durch welche eine höhere Produktivität erzielt wird.

Diese Aufgabe wird durch ein Verfahren zur Belichtung eines lichtempfindlichen Aufzeichnungsträgers, vorzugsweise zumindest einer gespeicherten Darstellung auf einem lichtempfindlichen Aufzeichnungsträger, mit einer Belichtungseinrichtung gelöst, bei welcher der zumindest eine Aufzeichnungsträger auf eine Auflage aufgelegt und positioniert wird, welcher als ein endloses Transportband ausgebildet ist und der zumindest eine Aufzeichnungsträger mit dem Transportband von der Beladestation in die Prozesskammer verfahren wird, wobei dem Transportband in der Beladestation zumindest eine erste Vakuumkammer und in der Prozesskammer zumindest eine zweite Vakuumkammer zugeordnet wird. Dies ermöglicht eine vereinfachte Handhabung und eine Verkürzung der Prozesszeiten. Durch dieses Transportband kann gemäß einer ersten Ausführungsform der Aufzeichnungsträger aus der Beladestation in die Prozesskammer eingefahren und in derselben Transportrichtung mit dem Transportband aus der Prozesskammer herausgeführt werden, wobei während dem Herausführen des belichteten Aufzeichnungsträgers mit derselben Verfahrbewegung des Transportbandes ein noch nicht belichteter Aufzeichnungsträger in die Prozesskammer eingeführt wird. Zudem kann die Prozesskammer durch dieses Transportband in einer definierten Ebene durchlaufen werden, sodass gleichbleibende Bedingungen im Hinblick auf die Belichtung des Aufzeichnungsträgers gegeben sind.

Bevorzugt wird das Transportband zur Belichtung des Aufzeichnungsträgers in der Prozesskammer stillgesetzt und ein weiterer Aufzeichnungsträger in einer Beladestation gleichzeitig auf das stillstehende Transportband aufgelegt. Dadurch kann ein gesichertes Auflegen des Aufzeichnungsträgers auf dem Transportband ermöglicht sein. Bei einer nachfolgenden Verfahrbewegung wird der belichtete Aufzeichnungsträger aus der Prozesskammer herausgeführt und parallel dazu der unbelichtete Aufzeichnungsträger in die Prozesskammer verfahren.

Eine vorteilhafte Ausführungsform des Verfahrens sieht vor, dass während dem Einfahren des Aufzeichnungsträgers in die Prozesskammer die Ist-Position und/oder Ist-Lage des Aufzeichnungsträgers auf dem Transportband erfasst und daraufhin der Belichtungskopf zum Aufbringen der Darstellung auf dem Aufzeichnungsträger oder zur Belichtung des Aufzeichnungsträgers angesteuert wird. Dadurch kann eine weitere Prozesszeitverkürzung gegeben sein, da während dem Verfahrweg des Aufzeichnungsträgers von einer Position außerhalb der Prozesskammer in die Prozesskammer diese Ist-Position und/oder Ist-Lage erfasst wird.

Der Aufzeichnungsträger wird bevorzugt durch einen Anschlag am Transportband ausgerichtet. Dadurch kann bereits eine definierte Positionierung des Aufzeichnungsträgers auf dem Transportband erzielt werden. Alternativ können auf dem Transportband Positionierstifte vorgesehen sein, welche vorzugsweise in Positionierbohrungen im Aufzeichnungsträger eingreifen. Dadurch kann passgenau ein Aufzeichnungsträger aufgenommen und transportiert werden.

Bevorzugt wird die zumindest erste Vakuumkammer nach dem Auflegen des Aufzeichnungsträgers und zumindest zu Beginn einer Transportbewegung des Transportbandes aktiviert. Durch das Zu- und Abschalten der ersten Vakuumkammer in der Beladestation kann eine vereinfachte Handhabung des Aufzeichnungsträgers ermöglicht sein. Des Weiteren wird bevorzugt die erste Vakuumkammer nach dem Einführen des Aufzeichnungsträgers in die Prozesskammer ausgeschalten. Somit kann der nachfolgende Aufzeichnungsträger wiederum vereinfacht auf das Transportband aufgelegt werden.

Des Weiteren wird bevorzugt in der Prozesskammer eine Endposition des Aufzeichnungsträgers für den Belichtungsvorgang durch zumindest einen Positionssensor erfasst. Dieser Positionssensor steuert bei der Erfassung der Endposition ein Stillsetzen des Transportbandes an, sodass daraufhin die Belichtung des Aufzeichnungsträgers durchgeführt werden kann. Dieser Positionssensor kann beispielsweise als eine Kamera, insbesondere CCD-Kamera, oder dergleichen ausgebildet sein.

Die der Erfindung zugrundeliegende Aufgabe wird durch eine Belichtungseinrichtung zur Belichtung eines lichtempfindlichen Aufzeichnungsträgers gelöst, bei welchem die Auflage für den zumindest einen Aufzeichnungsträger als ein endloses Transportband ausgebildet ist, welches sich zumindest von einer Beladestation vor der Prozesskammer der Belichtungseinrichtung zumindest bis zum Ende der Prozesskammer erstreckt und das Transportband ist in der Beladestation zumindest einer ersten Vakuumkammer und in der Prozesskammer zumindest einer zweiten Vakuumkammer zugeordnet, die separat zueinander ansteuerbar sind. Durch das Transportband kann beispielsweise ein Durchlaufbetrieb angesteuert werden, in dem während dem Belichten des oder der Aufzeichnungsträger in der Prozesskammer zumindest ein weiterer zu belichtender Aufzeichnungsträger in der Beladestation aufgelegt wird und nach der Belichtung des Aufzeichnungsträgers dieser aus der Prozesskammer herausgeführt und gleichzeitig der zu belichtende Aufzeichnungsträger in die Prozesskammer einfahrbar ist. Durch die separate Ansteuerung der ersten und zweiten Vakuumkammer kann nach dem Einfahren des Aufzeichnungsträgers von der Beladestation in die Prozesskammer die erste Vakuumkammer abgeschalten werden, um darauffolgend ein einfaches Beladen mit einem weiteren Aufzeichnungsträger zu ermöglichen. Dies ermöglicht eine Prozesszeitreduzierung, wobei diese Prozesszeit nur noch durch die Belichtungszeit des Aufzeichnungsträgers begrenzt ist.

Bevorzugt ist das Transportband als ein Vakuumtransportband ausgebildet. Dies ermöglicht eine schnelle Handhabung und Fixierung des Aufzeichnungsträgers auf dem Transportband.

Des Weiteren sind bevorzugt am Transportband Anschläge, Positionsmarken oder Positionspins zum Ausrichten des Aufzeichnungsträgers beim Auflegen auf das Transportband vorgesehen. Dadurch kann eine schnelle und vorzugsweise auch automatisierte Positionierung der Aufzeichnungsträger in der Beladestation auf das Transportband gegeben sein.

Des Weiteren erstreckt sich das Transportband bevorzugt bis in eine Entladestation, die sich an die Prozesskammer anschließt und gegenüberliegend zur Beladestation ausgerichtet. Somit kann in einem laufenden Produktionsprozess in der Beladestation ein Beladen des Aufzeichnungsträgers, in der Prozesskammer ein Belichten eines Aufzeichnungsträgers und in der Entladestation eine Entnahme des belichteten Aufzeichnungsträgers erfolgen. Vorzugsweise kann bei dieser Anordnung die Durchlaufrichtung oder die Transportförderrichtung des Transportbandes gleichbleibend vorgesehen sein. Alternativ kann auch ein Wechsel in der Verfahrbewegung des Transportbandes vorgesehen sein, das heißt, dass die Beladestation zum Be- und Entladen des Aufzeichnungsträgers und die Entladestation ebenfalls zum Be- und Entladen des Aufzeichnungsträgers dient. Zwischen den beiden Stationen ist die Prozesskammer vorgesehen. In diesem Fall ist jeweils eingangsseitig an der Prozesskammer eine Auswerteeinrichtung zur Erfassung der Ist-Position des Aufzeichnungsträgers oder der zumindest einen Darstellung auf dem Aufzeichnungsträger während der Einfahrbewegung in die Prozesskammer vorgesehen.

Des Weiteren kann das Transportband den belichteten Aufzeichnungsträger in ein Magazin oder eine Wendestation überführen, die gegenüberliegend zur Beladestation der Prozesskammer zugeordnet sind. Beispielsweise kann bei einer solchen Wendestation der Aufzeichnungsträger darauffolgend wiederum einer Belichtungseinrichtung zugeführt werden, sodass die zweite Seite des Aufzeichnungsträgers belichtet wird.

Des Weiteren ist bevorzugt vorgesehen, dass die Vakuumkammer eine zum Transportband weisende Stützkontur aufweist, welche Auflageflächenabschnitte umfasst, die durch in Transportrichtung fortlaufende Vertiefungen unterbrochen sind und dass im Bereich der Auflageflächenabschnitte Luft zugeführt und über die Vertiefungen Luft abgesaugt wird. Diese Stützkontur weist zum einen die Funktion auf, dass das Transportband schwebend oberhalb der Stützkontur gelagert wird, und zwar durch die zugeführte Luft über die Auflageflächenabschnitte. Diese Auflageflächenabschnitte können bevorzugt kleine Bohrungen aufweisen oder aus einem porösen Material ausgebildet sein, welches luftdurchlässig ist. Zum anderen kann über die Vertiefungen dann wiederum die zugeführte Luft abgesaugt werden.

Vorteilhafterweise weist das Transportband in Transportrichtung gesehen mehrere Reihen mit hintereinander angeordneten Durchbrechungen auf, welche sich in Längsrichtung der Vertiefungen der Stützkontur erstrecken. Dadurch wird ermöglicht, dass ein Vakuum zwischen einer Oberfläche des Transportbandes und dem darauf aufliegenden Aufzeichnungsträger geschaffen werden kann, so dass dieser in seiner einmal ausgerichteten Position von der Beladestation in die Prozesskammer und vorzugsweise aus der Prozesskammer heraus zur weiteren Bearbeitung abgeführt werden kann.

Die Erfindung sowie weitere vorteilhafte Ausführungsformen und Weiterbildungen derselben werden im Folgenden anhand der in den Zeichnungen dargestellten Beispiele näher beschrieben und erläutert. Es zeigen:
Figur 1 eine perspektivische Ansicht einer Belichtungseinrichtung,
Figur 2 eine schematische Seitenansicht der Belichtungseinrichtung gemäß Figur 1 mit einer Transportfördereinrichtung,
Figur 3 eine schematische Ansicht einer alternativen Ausführungsform der Belichtungseinrichtung zu Figur 2,
Figur 4 eine schematische Ansicht auf eine Vakuumkammer der Transporteinrichtung, und
Figur 5 eine schematische Schnittansicht entlang der Linie V-V in Figur 4.

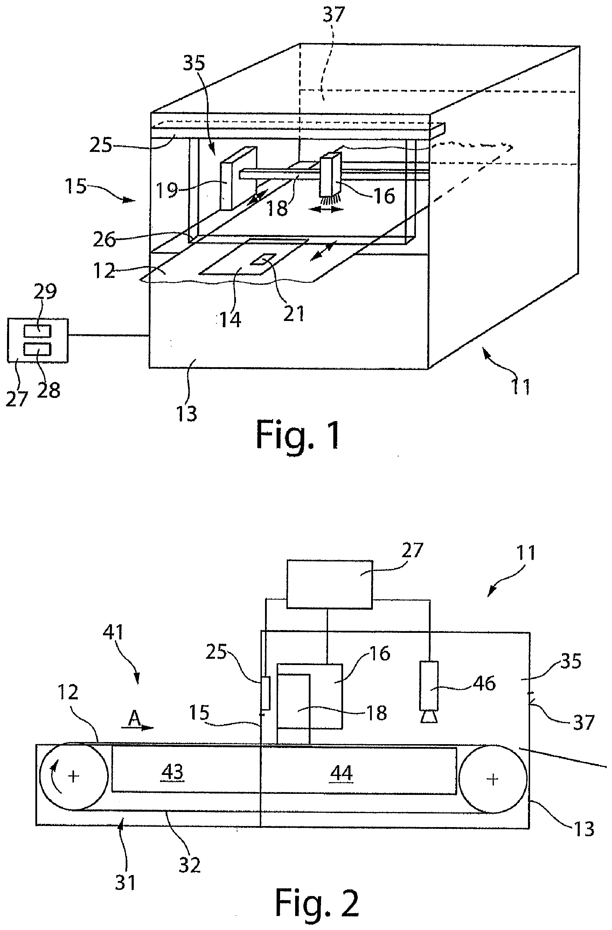

In Figur 1 ist schematisch vereinfacht eine Belichtungseinrichtung 11 dargestellt. Diese Belichtungseinrichtung 11 umfasst ein Gehäuse 13 mit einem Maschinengrundgestell. In Figur 1 ist eine Auflage 12 für ein oder mehrere Aufzeichnungsträger 14 dargestellt. Diese Auflage 12 ist Teil eines Transportbandes 32 einer Transportfördereinrichtung 31, welche schematisch in Figur 2 dargestellt ist. Durch diese Transportfördereinrichtung 31 kann der Aufzeichnungsträger 14 durch eine Gehäuseöffnung 15 in eine Prozesskammer 35 der Belichtungseinrichtung 11 positioniert werden. In dieser Prozesskammer 35 wird eine Belichtung des Aufzeichnungsträgers 14 durch zumindest einen Belichtungskopf 16 durchgeführt. Darauffolgend kann der belichtete Aufzeichnungsträger 14 über eine weitere Gehäuseöffnung 37 aus der Prozesskammer 35 herausgeführt werden. Die Transportfördereinrichtung 31 kann auf einer Basisplatte, insbesondere Granitplatte, gelagert sein.

Bei dem Aufzeichnungsträger 14 kann es sich beispielsweise um fotografische Vorlagen für gedruckte Leiterplatten sowie andere Gegenstände handeln, welche fototechnische Strukturen als Teil des Produktionsverfahrens einsetzen. Insbesondere können als Aufzeichnungsträger 14 resistbeschichtete Paneele, UV-Filme, Lötstopplacke, rotempfindliche, orthochromatische Filme oder Masken vorgesehen sein.

Zum Belichten solcher Aufzeichnungsträger 14 werden die Belichtungseinrichtungen 11 als sogenannte Direktbelichtungssysteme ausgebildet.

In der Prozesskammer 35 ist bevorzugt zumindest ein Belichtungskopf 16 angeordnet, der entlang einer Führung 18 in und entgegen der X-Richtung verfahrbar vorgesehen ist. Diese Führungsachse 18 ist mit einer Schlittenanordnung 19 in und entgegen der Y-Richtung in der Prozesskammer 35 verfahrbar. Zur Ansteuerung dieser Schlittenanordnung 19 sowie des zumindest einen Belichtungskopfes 16 ist eine Steuerung 27 vorgesehen. Diese Steuerung 27 ist computerprogrammgesteuert. Diese Steuerung 27 umfasst bevorzugt eine Bedienoberfläche 28 und ein Display 29, um einzelne Programme anzusteuern, aufzurufen und/oder einzustellen.

Die Prozesskammer 35 der Belichtungseinrichtung 11 umfasst der Gehäuseöffnung 15 zugeordnet eine Bilderfassungseinrichtung 25. Diese ist vorzugsweise linienförmig und kann in Form einer Scannleiste ausgebildet sein. Während einer Verfahrbewegung des Aufzeichnungsträgers 14 in die Prozesskammer 35 erfolgt eine Erfassung des Aufzeichnungsträgers 14 in der Lage und/oder Position und/oder es wird die Lage von zumindest einer Darstellung 21 auf dem Aufzeichnungsträger 14 erfasst. Aufgrund der erfassten Messpunkte, wobei wenigstens zwei - vorzugsweise drei - Messpunkte erfasst werden, kann der Aufzeichnungsträger 14 in seiner Ausrichtung auf der Auflage 12 bezüglich der X- und Y-Position erfasst werden. Diese erfassten Positionsdaten werden an die Steuerung 27 weitergeleitet. Diese Steuerung 27 umfasst eine Auswerteeinrichtung, um daraufhin den zumindest einen Belichtungskopf 16 bezüglich der Belichtung anzusteuern.

In Figur 2 ist eine schematische Seitenansicht der Belichtungseinrichtung 11 gemäß Figur 1 dargestellt. Die Transportfördereinrichtung 31 der Belichtungseinrichtung 11 erstreckt sich von einer Beladestation 41 in die Prozesskammer 35 hinein und vorzugsweise bis zum Ende der weiteren Gehäuseöffnung 37 der Prozesskammer 35. Diese Transportfördereinrichtung 31 umfasst ein endloses Transportband 32, welches durch zwei Umlenkrollen 33, 34 geführt und zumindest durch eine der beiden Umlenkrollen 33, 34 verfahrbar angesteuert wird. Das Transportband 32 ist bevorzugt als ein metallisches Band, insbesondere Stahlband, ausgebildet. An einer Unterseite des Transportbandes 32 ist eine erste und eine zweite Vakuumkammer 43, 44 zugeordnet. Die erste Vakuumkammer 43 erstreckt sich bevorzugt entlang der Beladestation 41, und die zweite Vakuumkammer 44 erstreckt sich vorzugsweise innerhalb der Prozesskammer 35. Die erste und zweite Vakuumkammer 43, 44 sind durch die Steuerung 27 bevorzugt getrennt ansteuerbar.

In der Prozesskammer 35 ist des Weiteren ein Positionssensor 46 vorgesehen, welcher nach dem Einfahren des Aufzeichnungsträgers 14 in die Prozesskammer 35 eine Position, insbesondere Endposition, des Aufzeichnungsträgers 14 erfasst und die Verfahrbewegung des Transportbewegung 32 stillsetzt.

Eine erste Ausführungsform des Verfahrens zur Belichtung des Aufzeichnungsträgers 14 mit der Belichtungseinrichtung 11 ist nachfolgend beschrieben:

In der Beladestation 41 wird ein unbelichteter Aufzeichnungsträger 14 auf das Transportband 32 aufgelegt. An oder im Transportband 32 können Anschläge, Positionsmarken und/oder Positionspins vorgesehen sein, um den Aufzeichnungsträger 14 daran zu positionieren und/oder auszurichten. Das Transportband 32 ist bevorzugt aus Edelstahl oder einem hochlegierten Stahl ausgebildet. Darauffolgend wird ein Vakuum der ersten Vakuumkammer 43 aktiviert und der Aufzeichnungsträger 14 auf dem Transportband 32 fixiert. Parallel dazu oder zeitlich versetzt kann die zweite Vakuumkammer 44 mit Vakuum beaufschlagt werden. Der Aufzeichnungsträger 14 wird aus der Beladestation 41 in die Prozesskammer 35 verfahren. Die Bilderfassungseinrichtung 25 erkennt die Lage und/oder Position des Aufzeichnungsträgers 14. Beim weiteren Einfahren wird eine Endposition des Aufzeichnungsträgers 14 durch die Positionssensor 46 erfasst und die Transportbewegung des Transportbandes 32 stillgesetzt. Gleichzeitig kann die erste Vakuumkammer 43 abgeschalten werden. Während dem Ruhen des Transportbandes 32 wird die Belichtung des Aufzeichnungsträgers 14 in der Prozesskammer 35 durchgeführt. Gleichzeitig erfolgt ein Beladen eines neuen Aufzeichnungsträgers 14 in der Beladestation 41. Nach dem Belichtungsprozess in der Prozesskammer 35 wird die erste Vakuumkammer 43 aktiviert und das Transportband 32 in derselben Fahrtrichtung angesteuert, sodass der belichtete Aufzeichnungsträger 14 aus der Prozesskammer 35 durch die Gehäuseöffnung 37 herausgeführt und der neue Aufzeichnungsträger 14 aus der Beladestation 41 in die Prozesskammer 35 eingeführt wird. Darauffolgend wiederholt sich der vorbeschriebene Vorgang.

Der Prozesskammer 35 nachgeschalten kann ein Magazin oder eine Wendestation zugeordnet sein, um die einseitig belichteten Aufzeichnungsträger 14 aufzunehmen und/oder zu entnehmen.

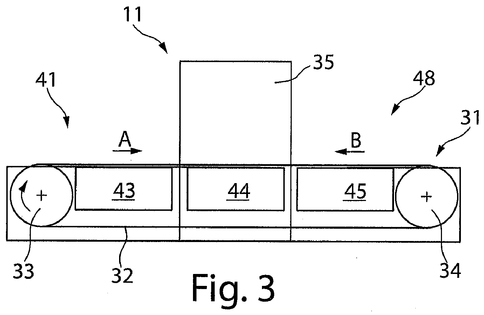

In Figur 3 ist eine alternative Aufzeichnungsträger 14 der Belichtungseinrichtung 11 zu Figur 2 dargestellt. Diese Ausführungsform der Belichtungseinrichtung 11 umfasst eine Transportfördereinrichtung 31, bei welcher sich das Transportband 32 von einer Beladestation 41 bis zu einer Entladestation 48 erstreckt und eine dazwischen angeordnete Prozesskammer 35 durchläuft. Dadurch kann das vorbeschriebene Verfahren durchgeführt werden, indem der belichtete Aufzeichnungsträger 14 aus der Prozesskammer 35 in die Entladestation 48 herausgeführt wird. Der auf dem Transportband 32 aufliegende belichtete Aufzeichnungsträger 14 kann manuell oder mit einer nicht näher dargestellten Handlingseinrichtung entnommen und einem Magazin zugeführt werden oder einer weiteren nachfolgenden Bearbeitungsstation. Bei dieser Ausführungsform ist die in Figur 3 dargestellte dritte Vakuumkammer 45 nicht erforderlich.

Die Belichtungseinrichtung 11 gemäß Figur 3 ermöglicht ein alternatives Verfahren zur Belichtung des lichtempfindlichen Aufzeichnungsträgers 14 im Vergleich zur Belichtungseinrichtung 11 gemäß Figur 2.

Die Beladestation 41 wird mit einem Aufzeichnungsträger 14 bestückt. Die erste Vakuumkammer 43 in der Beladestation 41 und die zweite Vakuumkammer 44 der Prozesskammer 35 werden aktiviert, das Transportband 32 wird gemäß Pfeil A verfahren, sodass der Aufzeichnungsträger 14 in die Prozesskammer 35 eingefahren wird. Während dem Stillstand des Transportbandes 32 zur Belichtung des in der Prozesskammer 35 sich befindenden Aufzeichnungsträger 14 wird in der Entladestation 48 ein zu belichtender Aufzeichnungsträger 14 für das Transportband 32 aufgelegt. Nach der Belichtung des Aufzeichnungsträgers 14 in der Prozesskammer 35 wird eine dritte Vakuumkammer 45 der Entladestation 48 aktiviert und das Transportband 32 gemäß Pfeil B angetrieben. Der belichtete Aufzeichnungsträger 14 wird in die Beladestation 41 und der weitere Aufzeichnungsträger 14 von der Entladestation 48 in die Prozesskammer 35 übergeführt. Anschließend erfolgt in der Beladestation 41 eine Entnahme des belichteten Aufzeichnungsträgers 14 und eine Bestückung mit einem zu belichtenden Aufzeichnungsträger 14. Danach erfolgt ein Antrieb des Transportbandes 32 wiederum in Pfeilrichtung A.

Jeweils nach dem Einführen des Aufzeichnungsträgers 14 aus der Beladestation 41 in die Prozesskammer 35 oder aus der Entladestation 48 in die Prozesskammer 35 wird die jeweilige Vakuumkammer 43, 45 ausgeschalten.

Die Belichtungseinrichtung 11 gemäß der Ausführungsform in Figur 3 weist sowohl der Gehäuseöffnung 15 als auch der Gehäuseöffnung 35 zugeordnet jeweils eine Bilderfassungseinrichtung 25 auf. Auch kann der Positionssensor 46 jeweils zu einem Ende der zweiten Vakuumkammer 44 positioniert sein, um in Abhängigkeit der jeweiligen Einfahrrichtung des Aufzeichnungsträgers 14 in die Prozesskammer 35 die Endposition zu erfassen.

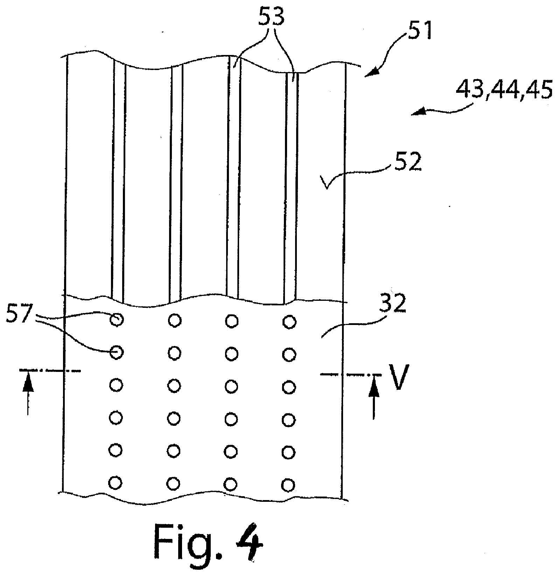

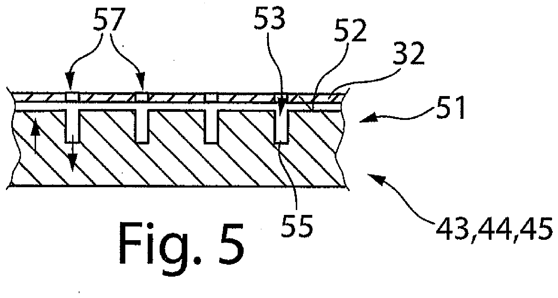

In Figur 4 ist eine schematische Ansicht auf eine Vakuumkammer 43, 44, 45 dargestellt. Die Figur 5 zeigt eine schematische Schnittansicht entlang der Linie V-V einer Stützkontur 51 der Vakuumkammer 43, 44, 45 sowie einem dazu positionierten Transportförderband 32. Diese Stützkontur 51 weist Auflageabschnitte 52 auf, welche durch Vertiefungen 53 getrennt sind. Diese Vertiefungen 53 sind bevorzugt U-förmig ausgebildet und erstrecken sich längs zur Transportrichtung. Durch diese Vertiefungen 53 sind die Auflageflächenabschnitte 52 jeweils voneinander getrennt. Die Breite der Auflageflächenabschnitte 52 entspricht wenigstens der doppelten Breite der Vertiefung 53. Die Auflageflächenabschnitte 52 weisen zum Transportband 32 weisend Bohrungen oder Öffnungen auf. Alternativ kann der Auflageflächenabschnitt 52 auch porös ausgebildet sein. Dadurch kann über eine nicht näher dargestellte Luftzuführung ein Ausströmen von Luft in Richtung auf das Transportband 32 erzeugt werden, so dass sich zwischen den Auflageflächenabschnitten 52 und dem Transportband 32 ein Luftkissen ausbildet.

Die Vertiefungen 53 weisen in deren Boden 55 Absaugöffnungen auf, über welche Luft über nicht näher dargestellte Absaugeinrichtungen abgesaugt wird.

In dem Transportband 32 sind mehrere Reihen von hintereinander angeordneten Durchbrechungen 57 vorgesehen. Die vorzugsweise parallel ausgerichteten Reihen der Durchbrechungen 57 sind in Transportrichtung gesehen oberhalb den Vertiefungen 53 ausgerichtet und bei einer Bewegung des Transportbandes 32 in Transportrichtung sind die Durchbrechungen 57 oberhalb der Vertiefungen 53 ausgerichtet. Dadurch kann zwischen dem Transportband 32 und dem darauf aufliegenden Aufzeichnungsträger 14 eine Haltekraft, insbesondere ein Vakuum erzeugt werden. Durch das Transportband 32, welches sich vorzugsweise entlang von mehreren Vakuumkammern 43, 44, 45 erstreckt, kann somit ein durchgehender Transport ermöglicht sein, bei welchem der Aufzeichnungsträger 14 zum Transportband 32 durch das Vakuum fixiert gehalten ist.

## Patentansprüche

1. Verfahren zur Belichtung eines lichtempfindlichen Aufzeichnungsträgers (14) mit einer Belichtungseinrichtung (11), welche zumindest einen Belichtungskopf (16) in einer Prozesskammer (35) zur Belichtung des Aufzeichnungsträgers (14) umfasst, mit zumindest einer Auflage (12), auf welche der zumindest eine Aufzeichnungsträger (14) positioniert und darauffolgend in die Prozesskammer (35) eingefahren wird und mit zumindest einer Bilderfassungseinrichtung (25), welche in Einfahrrichtung des Aufzeichnungsträgers (14) dem zumindest einen Belichtungskopf (16) vorgeschalten ist und mit einer Steuerung (27), welche die Ist-Position und/oder Ist-Lage des Aufzeichnungsträgers (14) oder der zumindest einen Darstellung (21) auf dem Aufzeichnungsträger (14) erfasst und in Abhängigkeit einer gespeicherten Sollposition des Aufzeichnungsträgers (14) für eine Belichtung der zumindest eine Belichtungskopf (16) ansteuert wird, **dadurch gekennzeichnet**
- dass die Auflage (12) als ein endloses Transportband (32) ausgebildet ist, auf welche der zumindest eine Aufzeichnungsträger (14) aufgelegt wird,
- dass der zumindest eine Aufzeichnungsträger (14) mit dem Transportband (32) von einer Beladestation (41) außerhalb der Prozesskammer (35) zumindest in die Prozesskammer (35) verfahren wird, und
- dass dem Transportband (32) in der Beladestation (41) zumindest eine erste Vakuumkammer (43) und in der Prozesskammer (35) zumindest eine zweite Vakuumkammer (44) zugeordnet ist, die separat durch eine Steuerung angesteuert werden.

2. Verfahren nach Anspruch 1, **dadurch gekennzeichnet, dass** das Transportband (32) zum Belichten des Aufzeichnungsträgers (14) stillgesetzt und ein weiterer Aufzeichnungsträger (14) gleichzeitig auf das stillstehende Transportband (32) in der Beladestation (41) aufgelegt wird.

3. Verfahren nach Anspruch 1 oder 2, **dadurch gekennzeichnet, dass** während dem Einführen des Aufzeichnungsträgers (14) in die Prozesskammer (35) die Ist-Position und/oder Ist-Lage des Aufzeichnungsträgers (14) durch die Bilderfassungseinrichtung (25) erfasst und darauffolgend der zumindest eine Belichtungskopf (16) zum Belichten des Aufzeichnungsträgers (14) angesteuert wird.

4. Verfahren nach einem der vorhergehenden Ansprüche, **dadurch gekennzeichnet, dass** der Aufzeichnungsträger (14) durch Anschläge auf dem Transportband (32) oder durch Positionspins, welche in Positionsbohrungen im Aufzeichnungsträger (14) eingreifen, ausgerichtet wird.

5. Verfahren nach einem der vorhergehenden Ansprüche, **dadurch gekennzeichnet, dass** die erste Vakuumkammer (43) nach dem Auflegen des Aufzeichnungsträgers (14) und vor Beginn einer Transportbewegung des Transportbandes (32) aktiviert wird.

6. Verfahren nach Anspruch 5, **dadurch gekennzeichnet, dass** die erste Vakuumkammer (43) nach dem Einführen des Aufzeichnungsträgers (14) in die Prozesskammer (35) ausgeschalten wird.

7. Verfahren nach einem der vorhergehenden Ansprüche, **dadurch gekennzeichnet, dass** in der Prozesskammer (35) eine Endposition des Aufzeichnungsträgers (14) nach dem Einführen des Aufzeichnungsträgers (14) in die Prozesskammer (35) für die Belichtung durch einen Positionssensor (46) erfasst wird.

8. Verfahren nach einem der vorhergehenden Ansprüche, **dadurch gekennzeichnet, dass** der in der Prozesskammer (35) belichtete Aufzeichnungsträger (14) mit dem Transportband (32) aus der Prozesskammer (35) herausgefahren und an ein Magazin oder eine Wendestation übergeben oder in einer Entladestation (48) positioniert wird.

9. Verfahren nach einem der vorhergehenden Ansprüche, **dadurch gekennzeichnet, dass** parallel zum Ausfahren des belichteten Aufzeichnungsträgers (14) aus der Prozesskammer (35) ein unbelichteter Aufzeichnungsträger (14) mit dem Transportband (32) in die Prozesskammer (35) eingeführt wird.

10. Belichtungseinrichtung zur Belichtung von zumindest einem lichtempfindlichen Aufzeichnungsträger (14), mit zumindest einem Belichtungskopf (16) in einer Prozesskammer (35) zur Belichtung des Aufzeichnungsträgers (14), mit zumindest einer Auflage (12), auf welcher der zumindest eine Aufzeichnungsträger (14) positionierbar ist, mit zumindest einer Bilderfassungseinrichtung (25), welche in Einfahrrichtung des Aufzeichnungsträgers (14) in die Prozesskammer (35) dem zumindest einen Belichtungskopfes (16) vorgeschalten ist, und mit einer Steuerung (27), welche die Ist-Position und/oder Ist-Lage des Aufzeichnungsträgers (14) und/oder der zumindest einen Darstellung (21) auf dem Aufzeichnungsträger (14) erfasst und in Abhängigkeit einer abgespeicherten Sollposition des Aufzeichnungsträgers (14) den zumindest einen Belichtungskopf (16) ansteuert, **dadurch gekennzeichnet,**
- **dass** die Auflage (12) für den zumindest einen Aufzeichnungsträger (14) als ein endloses Transportband (32) ausgebildet ist,
- **dass** sich das Transportband (32) zumindest von einer Beladestation (41) vor der Prozesskammer (35) zumindest bis zum Ende der Prozesskammer (35) erstreckt, und
- **dass** das Transportband (32) in der Beladestation (41) zumindest eine erste Vakuumkammer (43) und in der Prozesskammer (35) zumindest eine zweite Vakuumkammer (44) aufweist, die separat durch die Steuerung (27) ansteuerbar sind.

11. Belichtungseinrichtung nach Anspruch 10, **dadurch gekennzeichnet, dass** das Transportband (32) als ein Vakuumtransportband ausgebildet ist.

12. Belichtungseinrichtung nach Anspruch 10 oder 11, **dadurch gekennzeichnet, dass** das Transportband (32) Anschläge, Positioniermarken und/oder Positionierpins zum Ausrichten und/oder zur Aufnahme des Aufzeichnungsträgers (14) beim Auflegen auf das Transportband (32) aufweist.

13. Belichtungseinrichtung nach einem der Ansprüche 10 bis 12, **dadurch gekennzeichnet, dass** das Transportband (32) sich bis in eine sich an die Prozesskammer (35) anschließende Entladestation (48) erstreckt, die der Beladestation (41) gegenüberliegend angeordnet ist oder dass das Transportband (32) den Aufzeichnungsträger (14) aus der Prozesskammer (35) in ein Magazin oder eine Wendestation überführt.

14. Belichtungseinrichtung nach einem der Ansprüche 10 bis 13, **dadurch gekennzeichnet, dass** die Vakuumkammer (43, 44, 45) eine zum Transportband weisende Stützkontur (51) aufweist, welche Auflageflächenabschnitte (52) umfasst, die durch in Transportrichtung verlaufende Vertiefungen (53) unterbrochen sind, und dass im Bereich der Auflageflächenabschnitte (52) Luft zuführbar und über die Vertiefungen (53) Luft absaugbar ist.

15. Belichtungseinrichtung nach einem der Ansprüche 10 bis 14, **dadurch gekennzeichnet, dass** das Transportband (32) in Transportrichtung gesehen, mehrere Reihen von aneinandergereihten Durchbrechungen (57) aufweist, welche sich in Längsrichtung der Vertiefungen (53) erstrecken.

## Claims

1. Method for exposing a light-sensitive recording medium (14) with an exposure device (11), which comprises at least one exposure head (16) in a process chamber (35) for exposing the recording medium (14), with at least one support (12), on which the at least one recording medium (14) is positioned and subsequently moved into the process chamber (35), and with at least one image acquisition device (25), which is connected upstream of the at least one exposure head (16) in the direction of entry of the recording medium (14), and with a controller (27) which detects the actual position and/or actual orientation of the recording medium (14) or of the at least one representation (21) on the recording medium (14) and controls the at least one exposure head (16) as a function of a stored desired position of the recording medium (14) for exposure, **characterized in**
- **that** the support (12) is designed as an endless conveyor belt (32) on which the at least one recording medium (14) is placed,
- **that** the at least one recording medium (14) is moved with the conveyor belt (32) from a loading station (41) outside the process chamber (35) at least into the process chamber (35), and
- **that** at least one first vacuum chamber (43) is assigned to the conveyor belt (32) in the loading station (41) and at least one second vacuum chamber (44) is assigned to the conveyor belt (32) in the process chamber (35), which are controlled separately by a controller.

2. Method according to claim 1, **characterized in that** the conveyor belt (32) is stopped for exposing the recording medium (14) and a further recording medium (14) is simultaneously placed on the stationary conveyor belt (32) in the loading station (41).

3. Method according to claim 1 or 2, **characterized in that** during the introduction of the recording medium (14) into the process chamber (35), the actual position and/or actual orientation of the recording medium (14) is detected by the image acquisition device (25) and the at least one exposure head (16) is subsequently activated for exposing the recording medium (14).

4. Method according to one of the preceding claims, **characterized in that** the recording medium (14) is aligned by stops on the conveyor belt (32) or by positioning pins which engage in positioning holes in the recording medium (14).

5. Method according to one of the preceding claims, **characterized in that** the first vacuum chamber (43) is activated after the record medium (14) has been placed on the conveyor belt (32) and before a transport movement of the conveyor belt (32) begins.

6. Method according to claim 5, **characterized in that** the first vacuum chamber (43) is switched off after the recording medium (14) has been introduced into the process chamber (35).

7. Method according to one of the preceding claims, **characterized in that** an end position of the recording medium (14) is detected in the process chamber (35) by a position sensor (46) after the recording medium (14) has been introduced into the process chamber (35) for the exposure.

8. Method according to one of the preceding claims, **characterized in that** the recording medium (14) exposed in the process chamber (35) is moved out of the process chamber (35) with the conveyor belt (32) and transferred to a magazine or a turning station or positioned in an unloading station (48).

9. Method according to one of the preceding claims, **characterized in that** an unexposed recording medium (14) is introduced into the process chamber (35) with the conveyor belt (32) in parallel with the removal of the exposed recording medium (14) from the process chamber (35).

10. Exposure device for exposing at least one light-sensitive recording medium (14), with at least one exposure head (16) in a process chamber (35) for exposing the recording medium (14), with at least one support (12) on which the at least one recording medium (14) can be positioned, with at least one image acquisition device (25), which is connected upstream of the at least one exposure head (16) in the direction of entry of the recording medium (14) into the process chamber (35), and with a controller (27) which detects the actual position and/or actual orientation of the recording medium (14) and/or of the at least one representation (21) on the recording medium (14) and controls the at least one exposure head (16) as a function of a stored desired position of the recording medium (14), **characterized in**
- **that** the support (12) for the at least one recording medium (14) is designed as an endless conveyor belt (32),
- **that** the conveyor belt (32) extends at least from a loading station (41) in front of the process chamber (35) at least to the end of the process chamber (35), and
- **that** the conveyor belt (32) has at least one first vacuum chamber (43) in the loading station (41) and at least one second vacuum chamber (44) in the process chamber (35), which can be controlled separately by the controller (27).

11. Exposure device according to claim 10, **characterized in that** the conveyor belt (32) is designed as a vacuum conveyor belt.

12. Exposure device according to claim 10 or 11, **characterized in that** the conveyor belt (32) has stops, positioning marks and/or positioning pins for aligning and/or receiving the recording medium (14) when it is placed on the conveyor belt (32).

13. Exposure device according to one of claims 10 to 12, **characterized in that** the conveyor belt (32) extends into an unloading station (48) which adjoins the process chamber (35) and is arranged opposite the loading station (41), or **in that** the conveyor belt (32) transfers the recording medium (14) from the process chamber (35) into a magazine or a turning station.

14. Exposure device according to one of claims 10 to 13, **characterized in that** the vacuum chamber (43, 44, 45) has a supporting contour (51) which points towards the transport belt and comprises support surface sections (52) which are interrupted by depressions (53) running in the transport direction, and **in that** air can be supplied in the region of the support surface sections (52) and air can be extracted via the depressions (53).

15. Exposure device according to one of claims 10 to 14, **characterized in that** the conveyor belt (32), viewed in the transport direction, has a plurality of rows of openings (57) arranged in a row, which extend in the longitudinal direction of the depressions (53).

## Revendications

1. Procédé d'exposition d'un support d'enregistrement sensible à la luminaire (14) à l'aide d'un dispositif d'exposition (11) qui comprend au moins une tête d'exposition (16) dans une chambre de traitement (35) pour exposer le support d'enregistrement (14), avec au moins un support (12) sur laquelle le ou les supports d'enregistrement (14) sont positionnés puis introduits dans la chambre de traitement (35), et avec au moins un dispositif de saisie d'image (25) qui est placé en amont de la ou des têtes d'exposition (16) dans le sens d'introduction du support d'enregistrement (14), et avec une commande (27) qui détecte la position réelle et/ou l'emplacement réel du support d'enregistrement (14) ou de là au moins une représentation (21) sur le support d'enregistrement (14) et qui, en fonction d'une position de consigne mémorisée du support d'enregistrement (14), commande là au moins une tête d'exposition (16) pour une exposition, **caractérisé**
- **en ce que** le support (12) est conçu comme une bande transporteuse sans fin (32) sur laquelle est posé le au moins un support d'enregistrement (14),
- **en ce qu'**au moins un support d'enregistrement (14) est déplacé avec la bande transporteuse (32) depuis une station de chargement (41) à l'extérieur de la chambre de traitement (35) au moins dans la chambre de traitement (35), et
- **en ce qu'**au moins une première chambre à vide (43) est associée à la bande transporteuse (32) dans la station de chargement (41) et au moins une deuxième chambre à vide (44) est associée à la chambre de traitement (35), lesquelles sont commandées séparément par une commande.

2. Procédé selon la revendication 1, **caractérisé en ce que** la bande transporteuse (32) est immobilisée pour exposer le support d'enregistrement (14) et qu'un autre support d'enregistrement (14) est simultanément placé sur la bande transporteuse immobilisée (32) dans la station de chargement (41).

3. Procédé selon la revendication 1 ou 2, **caractérisé en ce que**, pendant l'introduction du support d'enregistrement (14) dans la chambre de traitement (35), la position réelle et/ou l'orientation réelle du support d'enregistrement (14) sont détectées par le dispositif de capture d'images (25), puis au moins une tête d'exposition (16) est commandée pour exposer le support d'enregistrement (14).

4. Procédé selon l'une des revendications précédentes, **caractérisé en ce que** le support d'enregistrement (14) est aligné à l'aide de butées sur la bande transporteuse (32) ou à l'aide de goupilles de positionnement qui s'engagent dans des trous de positionnement dans le support d'enregistrement (14).

5. Procédé selon l'une des revendications précédentes, **caractérisé en ce que** la première chambre à vide (43) est activée après la mise en place du support d'enregistrement (14) et avant le début d'un mouvement de transport de la bande transporteuse (32).

6. Procédé selon la revendication 5, **caractérisé en ce que** la première chambre à vide (43) est désactivée après l'introduction du support d'enregistrement (14) dans la chambre de traitement (35).

7. Procédé selon l'une des revendications précédentes, **caractérisé en ce que**, dans la chambre de traitement (35), une position finale du support d'enregistrement (14) est détectée par un capteur de position (46) après l'introduction du support d'enregistrement (14) dans la chambre de traitement (35) pour l'exposition.

8. Procédé selon l'une des revendications précédentes, **caractérisé en ce que** le support d'enregistrement (14) exposé dans la chambre de traitement (35) est sorti de la chambre de traitement (35) avec la bande transporteuse (32) et transféré vers un magasin ou une station de retournement ou positionné dans une station de déchargement (48).

9. Procédé selon l'une des revendications précédentes, **caractérisé en ce que**, parallèlement à la sortie du support d'enregistrement exposé (14) de la chambre de traitement (35), un support d'enregistrement non exposé (14) est introduit dans la chambre de traitement (35) à l'aide de la bande transporteuse (32).

10. Dispositif d'exposition servant à exposer au moins un support d'enregistrement photosensible (14), comprenant au moins une tête d'exposition (16) dans une chambre de traitement (35) pour exposer le support d'enregistrement (14), comprenant au moins un support (12) sur laquelle peut être positionné le au moins un support d'enregistrement (14), avec au moins un dispositif de saisie d'image (25) qui est placé en amont de là au moins une tête d'exposition (16) dans le sens d'entrée du support d'enregistrement (14) dans la chambre de traitement (35), et avec une commande (27) qui détecte la position réelle et/ou l'emplacement réel du support d'enregistrement (14) et/ou de là au moins une représentation (21) sur le support d'enregistrement (14) et commande là au moins une tête d'exposition (16) en fonction d'une position de consigne mémorisée du support d'enregistrement (14), **caractérisé**
- **en ce que** le support (12) pour le au moins un support d'enregistrement (14) est conçu comme une bande transporteuse sans fin (32),
- **en ce que** la bande transporteuse (32) s'étend au moins depuis une station de chargement (41) située avant la chambre de traitement (35) jusqu'à au moins l'extrémité de la chambre de traitement (35), et
- **en ce que** la bande transporteuse (32) comporte au moins une première chambre à vide (43) dans la station de chargement (41) et au moins une deuxième chambre à vide (44) dans la chambre de traitement (35), qui peuvent être commandées séparément par la commande (27).

11. Dispositif d'exposition selon la revendication 10, **caractérisé en ce que** la bande transporteuse (32) est conçue comme une bande transporteuse à vide.

12. Dispositif d'exposition selon la revendication 10 ou 11, **caractérisé en ce que** la bande transporteuse (32) comporte des butées, des repères de positionnement et/ou des broches de positionnement pour aligner et/ou recevoir le support d'enregistrement (14) lors de sa mise en place sur la bande transporteuse (32).

13. Dispositif d'exposition selon l'une des revendications 10 à 12, **caractérisé en ce que** la bande transporteuse (32) s'étend jusqu'à une station de déchargement (48) adjacente à la chambre de traitement (35) (48) qui est disposée en face de la station de chargement (41), ou **en ce que** la bande transporteuse (32) transfère le support d'enregistrement (14) de la chambre de traitement (35) vers un magasin ou une station de retournement.

14. Dispositif d'exposition selon l'une des revendications 10 à 13, **caractérisé en ce que** la chambre à vide (43, 44, 45) présente un contour de support (51) tourné vers la bande transporteuse, qui comprend des sections de surface d'appui (52) interrompues par des renfoncements (53) s'étendant dans le sens du transport, et **en ce que**, dans la zone des sections de surface d'appui (52), de l'air peut être amené et aspiré par les renfoncements (53) .

15. Dispositif d'exposition selon l'une des revendications 10 à 14, **caractérisé en ce que** la bande transporteuse (32) présente, vue dans le sens du transport, plusieurs rangées d'ouvertures (57) alignées les unes à côté des autres, qui s'étendent dans le sens longitudinal des renfoncements (53).
